## Europäisches Patentamt

## European Patent Office

## Office européen des brevets

(11) Veröffentlichungsnummer: **0 221 232**

**A2**

(12) # EUROPÄISCHE PATENTANMELDUNG

(21) Anmeldenummer: 86107336.9

(51) Int. Cl.⁴: **H01L 39/24** , H01L 39/12

(22) Anmeldetag: 30.05.86

Die Bezeichnung der Erfindung wurde geändert (Richtlinien für die Prüfung im EPA, A-III, 7.3).

(30) Priorität: 06.09.85 DE 3531769

(43) Veröffentlichungstag der Anmeldung:
13.05.87 Patentblatt 87/20

(84) Benannte Vertragsstaaten:
CH DE FR GB IT LI NL

(71) Anmelder: Kernforschungszentrum Karlsruhe GmbH
Weberstrasse 5 Postfach 3640
D-7500 Karlsruhe 1(DE)

(72) Erfinder: Flükiger, Rene, Dr.
Schneidemühlerstrasse 6 E
D-7500 Karlsruhe 2(DE)
Erfinder: Gauss, Stephen
Hirschsprung 4
D-7000 Stuttgart 80(DE)

(54) Verfahren zur Herstellung von Multifilament-Supraleiterdrähten des Verbindungstyps.

(57) Die Erfindung betrifft ein Verfahren zur Herstellung von Multifilament-Supraleiterdrähten aus $Nb_3Sn$- oder $V_3Ga$-Filamenten, eingebettet in einer Cu-oder Cu-Legierungs-Matrix, welche metallische Zusatzelemente aus der Gruppe Ti, Zr, Hf, V, Nb, Ta, Fe, Co, Ni in den Filamenten und/oder in der Matrix enthalten, mit vorbestimten supraleitenden Eigenschaften sowohl bei mittleren Magnetfeldern (unter 12 T) als auch bei hohen Magnetfeldern (12 T und höher), wobei die Ausgangsmaterialien mit oder ohne Umhüllung einem oder mehreren sich wiederholenden mechanischen Verformungsschritten mit einer abschließenden Reaktionsglühung im Temperaturbereich zwischen 550° und 1000°C unterzogen werden. Aufgabe der Erfindung ist es, ein Verfahren zur Herstellung solcher Multifilament-Supraleiterdrähte zu schaffen, mit welchem einerseits der hohe Zeit- und Energie-Aufwand zum Einbringen ternärer oder multinärer Zusätze in die supraleitende Verbindung vermieden wird, andererseits der Anteil des Zusatzstoffes (der Zusatzstoffe) auf einen vorbestimmten Wert und damit die gewünschten supraleitenden Eigenschaften eingestellt werden kann bzw. können. Die Aufgabe wird dadurch gelöst, daß die metallischen Zusätze in Pulverform mit einem Pulver aus Niob oder einer Niob-Legierung, oder aus Vanadium oder aus einer Vanadin-Legierung in bestimmter Korngröße und in einer bestimmten Menge gemischt wird, das erhaltene Pulvergemisch in einem Behälter aus Kupfer oder aus einer Kupfer-Legierung kompaktiert wird, der kompaktierte Behälter zu einem Draht verformt und nach Entfernen der Behälterschicht zu Drähten weiterverarbeitet wird und nach Maßgabe der gewünschten supraleitenden Eigenschaften die abschließende Reaktionsglühung der Drähte bei einer ausgewählten Temperatur im Bereich von 500°C bis 1000°C und bei einer ausgewählten Glühdauer im Bereich von 48 bis 300 Stunden durchgeführt wird.

## Verfahren zur Herstellung von Multifilament-Superleiterdrähten aus Nb₃Sn-oder V₃GA-Filamenten, eingebettet in einer Cu-oder Cu-Legierungs-Matrix, welche metallische Zusatzelemente enthalten, mit vorbestimmten supraleitenden Eigenschaften.

Die Erfindung betrifft ein Verfahren zur Herstellung von Multifilament-Supraleiterdrähten aus $Nb_3$Sn-oder $V_3$Ga-Filamenten, eingebettet in einer Cu-oder Cu-Legierungs-Matrix, welche metallische Zusatzelemente aus der Gruppe Ti, Zr, Hf, V, Nb, Ta, Fe, Co, Ni in den Filamenten und/oder in der Matrix enthalten, mit vorbestimmten supraleitenden Eigenschaften sowohl bei mittleren Magnetfeldern (unter 12 T) als auch bei hohen Magnetfeldern (12 T und höher), wobei die Ausgangsmaterialien mit oder ohne Umhüllung einem oder mehreren sich wiederholenden mechanischen Verformungsschritten mit einer abschließenden Reaktionsglühung im Temperaturbereich zwischen 550°C und 1000°C unterzogen werden.

Supraleiterdrähte, die für die Erzeugung hoher Magnetfelder ( > 12 T) eingesetzt werden, bestehen gewöhnlich aus $Nb_3$Sn-oder $V_3$Ga-Filamenten, die in einer Cu-oder Cu-Legierungs-Matrix eingebettet sind. Zur Verbesserung der supraleitenden Eigenschaften bei hohen Magnetfeldern wurden der supraleitenden intermetallischen Verbindung ternäre oder quaternäre Zusätze beigefügt.

. Multifilament-Supraleiterdrähte auf der Basis Bronze-$Nb_3$Sn mit ternären oder quaternären Zusätzen von beispielsweise Uran, Titan, Zirkonium, Hafnium, Vanadium, Tantal, Eisen, Nickel, Palladium, Aluminium oder andere sind aus der Veröffentlichung der europäischen Patentanmeldung Nr. 0 048 313 A1 bekannt. Diese Zusätze dienen dort der Verringerung des sogenannten Prestress-Effektes und wurden dem Niob und/oder Kupfer bzw. der Bronze zulegiert.Dieser Effekt ist eine Folge der unterschiedlichen Kontraktion in der Cu-Bronze und dem A15-Filament beim Abkühlen von 1000 K auf 4,2 K und wirkt sich vor allem auf die Stromtrageigenschaften bei hohen Magnetfeldern aus. Vor allem wird dadurch $J_c$ gegenüber dem spannungsfreien Zustand erheblich verringert. Bei dem selben äußeren Magnetfeld wird die Verringerung durch die Zusätze deutlich abgeschwächt.

Als Zusatzelement wird meist Tantal aber auch Titan und Nickel in das Ausgangsmaterial Nb bzw. V einlegiert (0,3 -30 Gew.-% Zusatzelement). Da diese Elemente hochschmelzende Metalle sind, müssen die Verbindungen in einem Elektronenstrahlofen hergestellt werden. Schmelzvorgänge in einem Elektronenstrahlofen sind sehr aufwendig und teuer. Um eine homogene Verteilung des Zusatzelementes zu erreichen, ist ein mehrfaches Umschmelzen im Elektronenstrahlofen notwendig.

Der Erfindung liegt die Aufgabe zugrunde, ein Verfahren zur Herstellung von Multifilament-Supraleiterdrähten aus $Nb_3$Sn-oder $V_3$Ga-Filamenten, eingebettet in einer Cu-oder Cu-Legierungs-Matrix zu schaffen, mit welchem einerseits der hohe Zeit-und Energie-Aufwand zum Einbringen ternärer oder multinärer Zusätze in die supraleitende Verbindung vermieden wird, andererseits der Anteil des Zusatzstoffes (der Zusatzstoffe) auf einen vorbestimmten Wert und damit die gewünschten supraleitenden Eigenschaften eingestellt werden kann bzw. können.

Die Aufgabe wird erfindungsgemäß dadurch gelöst, daß

a) ein Pulver aus einem oder mehreren metallischen Zusatzelementen oder aus einer oder mehreren Legierungen aus mindestens zwei Zusatzelementen mit einem Pulver

a₁) aus Niob, oder

a₂) aus einer oder mehreren Nb-Legierungen aus der Gruppe Nb-Ta, Nb-Ti, Nb-Zr oder

a₃) aus Vanadium oder

a₄) aus einer oder mehreren V-Legierungen aus der Gruppe V-Ta, V-Nb, V-Ti, V-Zr,

gemischt wird, wobei alle Pulver Korngrößen aufweisen im Bereich zwischen 0,1 $\mu$m und 500 $\mu$m Durchmesser und der Anteil y des bzw. der Zusatzmetalle im Pulvergemisch einem Gewichtsprozentwert innerhalb der Grenzen $0,1 \leq y \leq 50$ entspricht,

b) das aus a) erhaltene Pulvergemisch in einen kompaktierbaren und evakuierbaren Behälter aus Kupfer oder aus einer Kupferlegierung eingefüllt, die eingeschlossene Luftmenge entfernt und danach das Pulvergemisch mit dem geschlossenen Behälter durch einfaches oder isostatisches Pressen gemeinsam kompaktiert wird bis zu einer Pulverdichte von mehr als 90 % T.D.,

c) der kompaktierte Behälter in an sich bekannter Weise zu einem Draht mit einem Durchmesser im Bereich von 0,5 mm bis 15 mm verformt und nach Entfernen der äußeren Cu-oder Cu-Legierungs-Schicht nach einer der bekannten Verfahrensweisen zu $Nb_3$Sn-Drähten oder zu $V_3$Ga-Drähten weiterverarbeitet wird und

d) nach Maßgabe der gewünschten supraleitenden Eigenschaften die abschließende Reaktionsglühung der Drähte bei einer ausgewählten Temperatur im Bereich von 500 °C bis 1000°C und bei einer ausgewählten Glühdauer im Bereich von 48 bis 100 Stunden durchgeführt wird.

In einer vorteilhafter Ausbildung des erfindungsgemäßen Verfahrens weist das (die) Pulver des Zusatzelementes (der Zusatzelemente) und das Nb oder V als Bestandteil enthaltende Pulver gleiche oder ähnliche Duktilität auf.

Das Pulvergemisch wird in einem Cu-bzw. Cu-Legierungsrohr verpreßt und zu einem Stab verarbeitet, der dann wie bei den bekannten Verfahren weiterbearbeitet wird.

Mit den bekannten Methoden zur Herstellung von Nb₃Sn-oder V₃Ga-Multifilament-Supraleiterdrähten erhält man Produkte, welche bei hohen Magnetfeldern (18 T bis 20 T) kritische Stromdichtewerte von $10^4$ A/cm² aufweisen.

Um eine homogene Verteilung zu erreichen, sollten die Einschlüsse aus dem Zusatzmaterial kleiner 0,5 μm sein. Bei der Reaktionsglühung (ca. 550° -750°C 3 bis 10 Tage), bei der die supraleitende Phase Nb₃Sn bzw. V₃Ga entsteht, bildet sich gleichzeitig die Legierung mit dem Zusatzstoff aufgrund der Festkörperdiffusion. Je nach Wahl der Reaktionsbedingungen wird mehr oder weniger Zusatzstoff in der supraleitenden Phase gelöst.

Mit dem erfindungsgemäßen Verfahren können ternäre oder quaternäre Supraleiterdrähte hergestellt werden unter Umgehung des aufwendigen Elektronenstrahlschmelzens der Legierung (sofern es sich um Zulegierungen zum Nb-Kern handelt). Außerdem wird der Anteil des zulegierten Materials erst am Ende des Herstellungsprozesses durch die Wahl der Glühtemperatur und -dauer festgelegt.

Im folgenden wird die Erfindung anhand der Beschreibung eines Durchführungsbeispiels näher erläutert.

Beispiel:

Zur Herstellung der Proben wurde Niobpulver mit Korngrößen zwischen 106 und 125 μm verwendet. Seine Vickershärte betrug ca. 85 kg/mm². Der Zusatzstoff war Tantalpulver (ca. 20 μm Durchmesser; $H_V$ 100 -120 kg/mm²). Abgewogene Pulvermengen wurden gemischt und dann vorsichtig -damit sie sich nicht wieder entmischen -mit einem Trichter in ein unten verschlossenes Cu-Zr-Rohr geschüttet, dessen Länge ca. 7 cm und dessen Durchmesser 9 mm war. Um eine hohe Kompaktierung zu erreichen, wurde das Pulver schon bei Teilfüllungen des Rohrs mit ca. 200 MPa vorgepreßt. Zum Verschließen wurde ein Cr-Zr-Stopfen mit ca. 300 MPa von oben eingepreßt.

Anschließend erfolgte die Drahtherstellung, größtenteils durch Hämmern, teilweise auch durch Walzen. Um die Einschlüsse fein zu verteilen, ist eine Querschnittsflächenreduktion $R_a = 10^6$ erforderlich. Aufgrund der kleinen Probendurchmesser war es notwendig, den Leiter mehrfach zu bündeln.

Dazu wurde bei ca. 1 mm Drahtdurchmesser das Hüllmaterial mit verdünnter Salpetersäure abgeätzt und dann 19 Stücke des Leiters wieder in ein Cu-Zr-Rohr gebündelt. Die zweite Bündelung erfolgte in ein Bronzerohr, welches dann auf den Enddurchmesser von 0,6 mm gehämmert wurde.

Die abschließende Reaktionsglühung, bei der die Nb₃Sn-A15-Struktur entstand, erfolgte bei Temperaturen zwischen 675°C und 750°C und einer Glühdauer im Bereich von 64 bis 100 Stunden. Aus den Kurven (1 bis 3 nach dem erfindungsgemäßen Verfahren; 4 bis 6 nach den zum Stande der Technik gehörigen Verfahren)

1 (für 85 Gew.-% Nb, 15 Gew.-% Ta; 675°C 100 h),

2 (für 85 Gew.-% Nb, 15 Gew.-% Ta; 700°C 64 h),

3 (für 85 Gew.-% Nb, 15 Gew.-% Ta; 750°C 64 h),

4 (für 100 Gew.-% Nb, d.h. Nb₃Sn ohne Zusatzelemente; 700°C 64 h),

5 (für 92,5 Gew.-% Nb, 7,5 Gew.-% Ta; 700°C 64 h),

6 (für 90,7 Gew.-% Nb, 9,3 Gew.-% Ta; 750°C 96 h), der nachfolgenden Figur ist erkennbar, daß der Ta-Zusatz von 15 Gew.-% bezogen auf den Nb + Ta-Anteil im (Nb,Ta)₃Sn in Verbindung mit Reaktions-Temperatur und -Zeit die Einstellung vorbestimmter Eigenschaften der supraleitenden Drähte sowohl bei Feldern unter 12 T als auch bei Feldern von 12 T und höher ermöglicht. Die Kurven 4 und 5 spiegeln die Ergebnisse aus E.Drost, F.Flükiger, W.Specking, Cryogenics 24, 622 - (1984) wieder, die Kurve 6 solche aus J.D.Livingston, IEEE Trans.Magn. MAG-14, 611 - (1978). Für Reaktionen bei Temperaturen unter 700°C erhält man Stromtragfähigkeitswerte wie bei guten binären Leitern, oberhalb von 700°C wie bei ternären bzw. multinären Leitern.

Das Herstellungsverfahren könnte verbessert werden, wenn der Ausgangsdurchmesser so groß gewählt würde, daß eine Bündelung nicht mehr notwendig wäre.

Die Verarbeitbarkeit der anderen bekannten Zulegierungs-Materialien (wie z.B. Ta, Ti, Zr, Hf, V, Fe, Co, Ni oder Nb bei V₃Ga) ist ähnlich der des Tantals. Verunreinigungen durch Sauerstoff, Kohlenstoff und Stickstoff in den Startmaterialien sind zu vermeiden. Die Vickershärte der gemischten Pulver müß ungefähr gleich hoch sein, damit sich die beiden Pulversorten gleichmäßig verformen.

Das Herstellungsverfahren wurde nach der Bronze-Methode durchgeführt, der gewünschte Supraleiterdraht ließe sich aber auch nach dem ähnlichen Verfahren der Internen-Zinndiffusion produzieren.

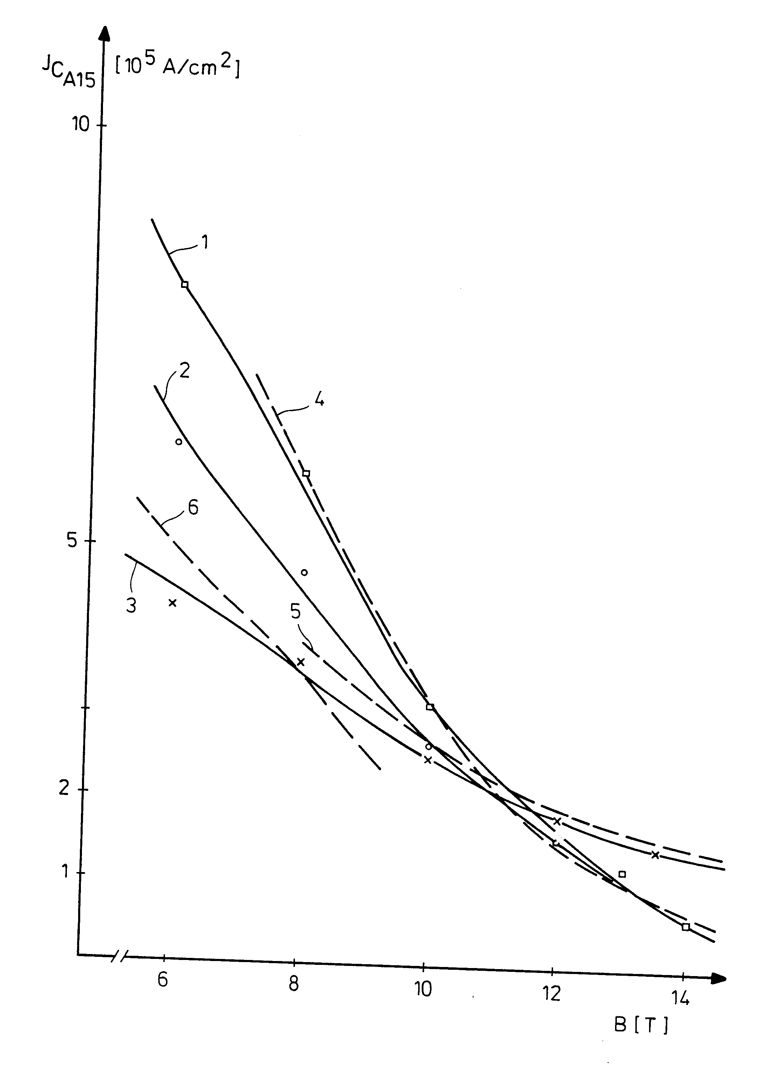

**Ansprüche**

1. Verfahren zur Herstellung von Multifilament-Supraleiterdrähten aus Nb$_3$Sn-oder V$_3$Ga-Filamenten, eingebettet in einer Cu-oder Cu-Legierungs-Matrix, welche metallische Zusatzelemente aus der Gruppe Ti, Zr, Hf, V, Nb, Ta, Fe, Co, Ni in den Filamenten und/oder in der Matrix enthalten, mit vorbestimmten supraleitenden Eigenschaften sowohl bei mittleren Magnetfeldern (unter 12 T) als auch bei hohen Magnetfeldern (12 T und höher), wobei die Ausgangsmaterialien mit oder ohne Umhüllung einem oder mehreren sich wiederholenden mechanischen Verformungsschritten mit einer abschließenden Reaktionsglühung im Temperaturbereich zwischen 550°C und 1000°C unterzogen werden, dadurch gekennzeichnet, daß

a) ein Pulver aus einem oder mehreren metallischen Zusatzelementen oder aus einer oder mehreren Legierungen aus mindestens zwei Zusatzelementen mit einem Pulver

a$_1$) aus Niob, oder

a$_2$) aus einer oder mehreren Nb-Legierungen aus der Gruppe Nb-Ta, Nb-Ti, Nb-Zr oder

a$_3$) aus Vanadium oder

a$_4$) aus einer oder mehreren V-Legierungen aus der Gruppe V-Ta, V-Nb, V-Ti, V-Zr,

gemischt wird, wobei alle Pulver Korngrößen aufweisen im Bereich zwischen 0,1 $\mu$m und 500 $\mu$m Durchmesser und der Anteil y des bzw. der Zusatzmetalle im Pulvergemisch einem Gewichtsprozentwert innerhalb der Grenzen 0,1 $\leq$ y $\leq$ 50 entspricht,

b) das aus a) erhaltene Pulvergemisch in einen kompaktierbaren und evakuierbaren Behälter aus Kupfer oder aus einer Kupferlegierung eingefüllt, die eingeschlossene Luftmenge entfernt und danach das Pulvergemisch mit dem geschlossenen Behälter durch einfaches oder isostatisches Pressen gemeinsam kompaktiert wird bis zu einer Pulverdichte von mehr als 90 % T.D.,

c) der kompaktierte Behälter in an sich bekannter Weise zu einem Draht mit einem Durchmesser im Bereich von 0,5 mm bis 15 mm verformt und nach Entfernen der äußeren Cu-oder Cu-Legierungs-Schicht nach einer der bekannten Verfahrensweisen zu Nb$_3$Sn-Drähten oder zu V$_3$Ga-Drähten weiterverarbeitet wird und

d) nach Maßgabe der gewünschten supraleitenden Eigenschaften die abschließende Reaktionsglühung der Drähte bei einer ausgewählten Temperatur im Bereich von 550°C bis 1000°C und bei einer ausgewählten Glühdauer im Bereich von 48 bis 300 Stunden durchgeführt wird.

2. Verfahren nach Anspruch 1, dadurch gekennzeichnet, daß das (die) Pulver des Zusatzelementes (der Zusatzelemente) und das Nb oder V als Bestandteil enthaltende Pulver gleiche oder ähnliche Duktilität aufweisen.